(19) Europäisches Patentamt / European Patent Office / Office européen des brevets

(11) **EP 2 811 001 A1**

(12) **EUROPEAN PATENT APPLICATION**
published in accordance with Art. 153(4) EPC

(43) Date of publication:
**10.12.2014 Bulletin 2014/50**

(51) Int Cl.:
*C09K 11/08* [(2006.01)]     *C09K 11/00* [(2006.01)]
*C09K 11/54* [(2006.01)]

(21) Application number: **13742878.5**

(22) Date of filing: **29.01.2013**

(86) International application number:
**PCT/KR2013/000707**

(87) International publication number:
**WO 2013/115542 (08.08.2013 Gazette 2013/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.01.2012 KR 20120009048**

(71) Applicant: **Kookmin University Industry Academy Cooperation Foundation
Seongbuk-gu, Seoul 136-702 (KR)**

(72) Inventor: **DO, Young-Rag
Seoul 138-911 (KR)**

(74) Representative: **Michalski Hüttermann & Partner
Patentanwälte mbB
Speditionstraße 21
40221 Düsseldorf (DE)**

(54) **PHOSPHOR MATRIX COMPOSITE POWDER MINIMIZING LIGHT SCATTERING, AND LED STRUCTURE CONTAINING SAME**

(57)     This invention relates to a phosphor-matrix composite powder for minimizing light scattering and to an LED structure including the same, wherein the phosphor-matrix composite powder satisfying certain relation is prepared and the LED structure including the same is manufactured, thus minimizing light scattering and reflection and maximizing package efficiency.

FIG.4A

EP 2 811 001 A1

**Description**

BACKGROUND OF THE INVENTION

1. Field of the Invention

The present invention relates to a phosphor-matrix composite powder for minimizing light scattering and an LED structure including the same, and more particularly, to a phosphor-matrix composite powder for minimizing light scattering and an LED structure including the same, wherein the phosphor-matrix composite powder satisfies certain relation, thus minimizing light scattering and reflection and maximizing package efficiency.

2. Description of the Related Art

Among methods of manufacturing white LEDs known to date, the easiest method is a white phosphor-converted LED (pc-LED) method including applying a $Y_3Al_5O_{12}$:$Ce^{3+}$ (YAG:Ce) phosphor on a blue InGaN LED chip to combine blue light passed through the phosphor with yellow light emitted from the phosphor to form white light.
The white pc-LED was first manufactured by applying a mixture of a YAG:Ce yellow powder phosphor and a silicone binder on an LED chip. Recently, to increase a color rendering index and easily adjust the color temperature, green and red powder phosphors instead of yellow are applied, so that a white color is obtained by the three colors: blue, green and red. Micro-sized powder phosphor has been utilized until now to manufacture the white pc-LED, but powder phosphor is disadvantageous because light conversion efficiency from blue excited light to light emitted from the phosphor is remarkably decreased due to loss of emitted light and loss of excited light by scattering/reflection loss.
Specifically, to evaluate the light conversion loss by the pc-LED, the light conversion efficiency may be represented by Relation 1 below.

<Relation 1>

$$\text{Light conversion efficiency = photon quantity of light emitted from phosphor/photon quantity of blue light consumed by LED}$$

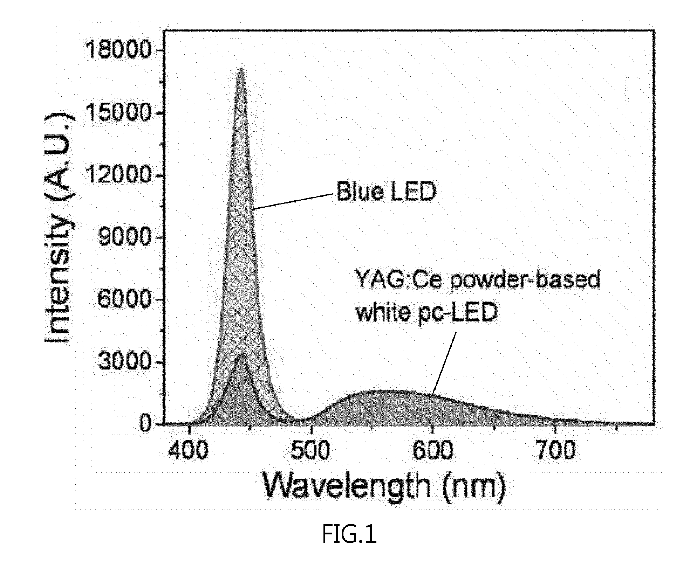

In Relation 1, the photon quantity of blue light consumed by an LED is determined by subtracting the photon quantity of transmitted blue light remaining after consumption by the LED from the blue photon quantity emitted from the blue LED. FIG. 1 is a graph illustrating the light emission spectrum of the blue LED and the white LED, and the light conversion efficiency may be easily determined from the light emission spectrum of the blue LED and the light emission spectrum of the white LED made using the blue LED (light conversion efficiency = photon quantity of yellow light of white LED / (total photon quantity of blue LED - photon quantity of blue transmitted light of white LED)).
For the white LED using a currently available power chip, the light conversion efficiency may be approximately 58% at 350 mA (rated current). The light conversion efficiency may be represented by Relation 2 below, depending on the deterioration factors.

<Relation 2>

$$\text{Light conversion efficiency = internal quantum efficiency of phosphor x LED package efficiency}$$

In Relation 2, the low LED package efficiency may be caused by loss due to scattering/reflection and loss due to low light extraction. For the power chip white LED coated with the YAG:Ce powder phosphor, the light conversion efficiency is 0.55. As such, the internal quantum efficiency of the YAG:Ce powder phosphor is about 0.88. In Relation 2, the package efficiency is about 0.66 (66%), and thus a considerably large amount of light is lost due to scattering/reflection and low light extraction in the course of conversion from blue to yellow; and for the powder phosphor, light is mainly lost by scattering/reflection. Assuming that light loss due to scattering/reflection is completely removed, the light conversion efficiency is theoretically considered to be increased by about 51% compared to conventional phosphors. Although the conventional powder phosphor is relatively large in the amount of scattering loss, it is currently useful for white pc-LEDs because of its advantages including easy mass production, easy application to LEDs and high internal quantum efficiency. However, in order to solve problems of the considerably large efficiency loss due to scattering/reflection, research and development is ongoing into nanophosphors and transparent ceramic plate phosphors, in lieu of conventional powder phosphor, as novel technologies wherein scattering seldom occurs.

Based on the Mie scattering principle, when the size of the nanophosphors is 50 nm or less, the scattering loss of visible light disappears. Accordingly, a variety of methods of synthesizing nanophosphors from an light conversion phosphor such as YAG:Ce are under study. However, application of the nanophosphors to LEDs may incur another problem. Specifically, when nanophosphors are mixed with a conventional silicone or polymer binder, the nanophosphors may aggregate and may thus cause secondary scattering, undesirably resulting in light loss. Furthermore, for YAG:Ce nanophosphors developed to date, the internal quantum efficiency is about 60% which is evaluated to be much lower than that of conventional powder phosphors.

Despite such drawbacks, thorough research is being carried out into nanophosphors and phosphor films with the expectation that the quantum efficiency of nanophosphors will be increased as high as that of the conventional powder phosphor and that a transparent nanophosphor/matrix composite film will be developed to reduce scattering loss. However, the nanophosphor/matrix composite film may still cause light extraction loss due to a wave-guiding effect as a total reflection phenomenon which deteriorates light extraction efficiency. Hence, a novel light extraction structure has to be devised. Accordingly, in order to replace the conventional micro-sized powder phosphor with nanophosphor, there is a need for more specific efforts for resolving problems of low internal quantum efficiency, deteriorated scattering due to secondary aggregation and low light extraction efficiency of the nanophosphor/matrix composite film.

SUMMARY OF THE INVENTION

Therefore, the present invention has been made keeping in mind the problems encountered in the prior art, and an object of the present invention is to provide a phosphor-matrix composite powder and an LED structure including the same, wherein the phosphor-matrix composite powder satisfying certain relation is prepared and the LED structure including the same is manufactured, thus minimizing light scattering and reflection and maximizing package efficiency.

In order to accomplish the above object, the present invention provides a phosphor-matrix composite powder for minimizing light scattering, comprising a matrix and a plurality of phosphors or quantum dots having a size of 100 nm or less dispersed in the matrix, wherein the composite satisfies Relation 3 below and is used as a light source for absorbing blue or near-ultraviolet light to emit visible light:

<Relation 3>

    a) Composite size $\geq$ 20 $\mu$m; and
    b) Surface root-mean-square-roughness ($R_q$) of composite $\leq$ 50 nm;.

In addition, the present invention provides a phosphor-matrix composite powder for minimizing light scattering, comprising a core layer comprising a matrix having a size of 20 $\mu$m or more and a shell layer comprising a plurality of phosphors or quantum dots having a size of 100 nm or less, wherein the composite satisfies Relation 3 below and is used as a light source for absorbing blue or near-ultraviolet light to emit visible light:

<Relation 3>

    a) Composite size $\geq$ 20 $\mu$m; and
    b) Surface root-mean-square-roughness ($R_q$) of composite $\leq$ 50 nm;.

Also, the composite powder may have a size of 30 ~ 500$\mu$ m.

Also, the composite powder may have a spherical shape, a cylindrical shape or a cubic shape.

Also, the phosphors may comprise at least one selected from the group consisting of $(Y_xGd_{1-x})_3(Al_yGa_{1-y})_5O_{12}$:Ce (x = 0.0-3.0, y = 0.0~5.0), $(Tb_xGd_{1-x})_3(Al_yGa_{1-y})_5O_{12}$:Ce (x = 0.0-3.0, y = 0.0~5.0), $Mg_3(Y_xGd_{1-x})_2Ge_3O_{12}$:Ce (x = 0.0~2.0), $CaSc_2O_4$:Ce, $Ca_3Sc_2Si_3O_{12}$:Ce, $(Sr_x,Ba_y,Ca_z)MgSi_2O_6$:Eu,Mn (x, y, z = 0.0-1.0, x+y+z = 1.0), $(Sr_x,Ba_y,Ca_z)_3MgSi_2O_8$:Eu,Mn (x, y, z = 0.0-3.0, x+y+z = 3.0), $(Sr_x,Ba_y,Ca_z)MgSiO_4$:Eu,Mn (x, y, z = 0.0-1.0, x+y+z = 1.0), $Lu_2CaMg_2(Si_x,Ge_{1-x})_3O_{12}$:Ce (x = 0.0~3.0), $(Sr_x,Ba_y,Ca_z)_2SiO_4$:Eu (x, y, z = 0.0-2.0, x+y+z = 2.0), $(Sr_x,Ba_y,Ca_z)_3SiO_5$:Eu (x, y, z = 0.0-3.0, x+y+z = 3.0), $(Sr_x,Ba_y,Ca_z)_3SiO_5$:Ce,Li (x, y, z = 0.0~3.0,x+y+z = 3.0), $Li_2SrSiO_4$:Eu, $LaSr_2AlO_5$:Ce, $Ca_2BO_3Cl$:Eu, $Y_3Mg_2AlSi_2O_{12}$:Ce, $BaMgAl_{10}O_{17}$:Eu, $Sr_2BaAlO_4F$:Ce, $(Sr_x,Ba_y,Ca_z)Ga_2S_4$:Eu (x, y, z = 0.0-1.0, x+y+z = 1.0), $Ba_2ZnS_3$:Ce,Eu, $Ca_2SiS_4$:Eu, Caα-SiALON:Yb, Caα-SiALON:Eu, α-SiALON:Yb, α-SiALON:Eu, Ca-Li-α-SiALON:Eu, β-SiALON:Eu, γ-AlON:Mn, γ-AlON:Mn,Mg, $(Sr_x,Ba_y,Ca_z)_2Si_5N_8$:Eu (x, y, z = 0.0-2.0, x+y+z = 2.0), $(Sr_x,Ba_y,Ca_z)Si_2O_2N_2$:Eu (x, y, z = 0.0~1.0, x+y+z = 1.0), $Ca_xAl_{12}(ON)_{16}$:Eu, $Ba_3Si_6O_{12}N_2$:Eu, $(Ba_{1-x}Sr_x)_YSi_4O_7$:Eu (x = 0.0~1.0), $(Ca_{1-x}Sr_x)AlSiN_3$:Eu (x = 0.0-1.0), and AlN:Eu.

Also, the composite powder may be transparent.

Also, the mixing ratio of the matrix and the phosphors may be 99.99 : 0.01 ~ 50 : 50 by mass.

Also, the matrix may comprise a transparent material having a high refractive index.

Also, the matrix may be alumina, silicate, $TiO_2$, $HfO_2$, $CeO_2$, $Y_2O_3$, $Gd_2O_3$ or a silicone-based resin.

Also, the quantum dots may comprise at least one selected from the group consisting of CdSe/ZnS, $CuInS_2$/ZnS, $Cu_2In_5S_8$/ZnS, $AgInS_2$/ZnS, $Ag_2In_5S_8$/ZnS, and InP/ZnS.

Also, the composite may be an organic dye-linked organic-inorganic nanocomposite.

Also, the organic dye-linked organic-inorganic nanocomposite may be an organic dye-bridged organic-inorganic nanocomposite.

Also, the organic dye-bridged organic-inorganic nanocomposite may be prepared by subjecting a red dye- or green dye-bridged alkoxysilane-based nanocomposite to a sol-gel reaction to prepare an oligosiloxane composite which then undergoes a condensation reaction.

Also, the shell layer may have a thickness of 5 ~ 100 nm.

In addition, the present invention provides an LED structure, comprising a blue or near-ultraviolet LED and the aforementioned composite bonded thereto.

According to the present invention, a phosphor-matrix composite powder and an LED structure including the same can minimize light scattering and reflection, thus exhibiting remarkably improved package efficiency compared to conventional powder phosphors, nano and ceramic plate phosphors, and phosphor-matrix composites.

## BRIEF DESCRIPTION OF THE DRAWINGS

The above and other objects, features and advantages of the present invention will be more clearly understood from the following detailed description taken in conjunction with the accompanying drawings, in which:

FIG. 1 is a graph illustrating the light emission spectrum of a blue LED and a white LED;
FIG. 2 is a graph illustrating the phosphor size versus the scattering coefficient based on the Mie scattering principle;
FIG. 3 is a graph illustrating the surface root-mean-square roughness ($R_q$) of the phosphor versus the scattering coefficient based on the Mie scattering principle; and
FIGS. 4A and 4B are schematic views illustrating composites according to preferred embodiments of the present invention.

## DESCRIPTION OF SPECIFIC EMBODIMENTS

Hereinafter, a detailed description will be given of the present invention with reference to the appended drawings.

As mentioned above, when a conventional phosphor-matrix composite powder having high scattering loss is applied to LEDs, package efficiency may decrease, undesirably resulting in remarkably lowered light conversion efficiency.

Hence, an embodiment of the present invention addresses a phosphor-matrix composite powder for minimizing light scattering, which is configured such that a plurality of phosphors or quantum dots having a size of 100 nm or less is dispersed in a matrix, the composite satisfying Relation 3 below and being used as a light source for absorbing blue/near-ultraviolet light to emit visible light:

<Relation 3>

a) Composite size $\geq$ 20 $\mu$m; and

b) Surface root-mean-square-roughness ($R_q$) of composite $\leq$ 50 nm;.

When manufacturing an LED including the composite satisfying the conditions a) and b) of Relation 3, light scattering and reflection may be minimized and package efficiency may be maximized.

Below is a description of a phosphor-matrix composite powder according to a first embodiment of the present invention.

The phosphor-matrix composite powder according to the first embodiment of the present invention is configured such that a plurality of phosphors or quantum dots having a size of 100 nm or less is dispersed in a matrix, and the composite powder satisfies the conditions of Relation 3. Specifically, the composite according to the present invention is applied to a phosphor useful as a light source for absorbing blue or near-ultraviolet light to emit visible light, and has to satisfy the conditions a) and b) of Relation 3.

The condition a) of Relation 3 is described below. As known in the art, to eliminate scattering of visible light, the phosphor size has to be decreased to 100 nm or less, and thus thorough research into nanophosphors is ongoing. In addition to the decrease in the phosphor size, scattering may be reduced based on the Mie scattering principle even when the size of a phosphor-matrix composite crystal is greater than that of a conventional composite.

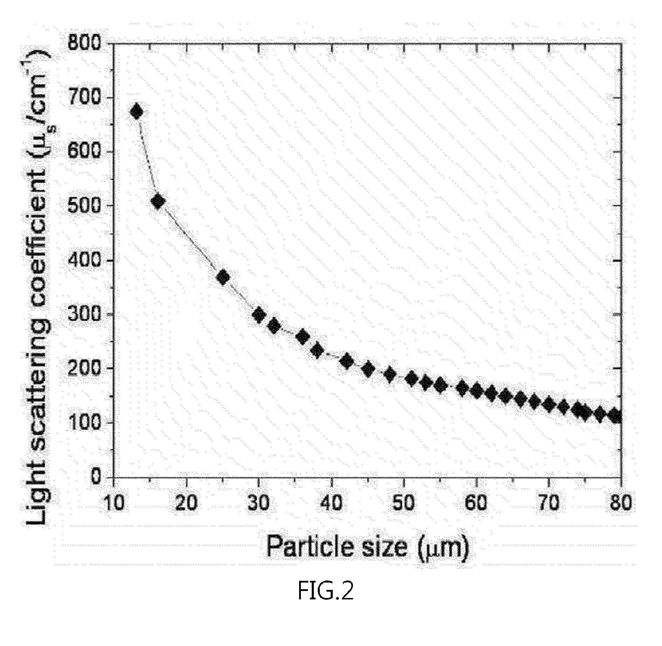

The phosphors and/or the quantum dots, which are dispersed in the matrix, have to have a size of 100 nm or less to minimize light scattering based on the Mie scattering principle. The composite powder comprising the phosphors and/or the quantum dots having a size of 100 nm or less should essentially satisfy Relation 3. In this regard, FIG. 2 is a graph illustrating the particle size versus the scattering coefficient based on the Mie scattering principle. Thus, when the particle size is at least 20 $\mu$m and preferably 30 $\mu$m or more, the scattering coefficient may be significantly lowered due to the crystal particles. A novel phosphor-matrix composite powder that is able to greatly lower the scattering loss should have a size of 50 nm or less or 20 $\mu$m or more based on the Mie scattering principle. When the size of the phosphor-matrix composite powder is 50 nm or less, internal quantum efficiency may decrease and light scattering may also be caused by secondary aggregation. Hence, in the present invention, the size of the phosphor-matrix composite powder has to be essentially set to 20 $\mu$m or more, and preferably 30 ~ 500 $\mu$m.

Particularly, the size of the micro-sized phosphor-matrix composite powder for minimizing light scattering may be calculated by Relation 4 to 6 below.

<Relation 4>

$$Q = 2 - (4/\rho)\sin + (4/\rho^2)(1-\cos\rho)$$

In this relation, p= $2y((n_1/n_0)-1)$, y = $2\pi a n_0/\lambda$, where $n_1$ and $n_0$ are the refractive indexes of a scattering body (phosphor-matrix composite) and a matrix, $\lambda$ is the wavelength of incident light, $a$ is the diameter (nm) of the scattering body (phosphor-matrix composite), and Q is the scattering efficiency.

The light scattering cross-section value of a particle is represented by $\sigma$ of Relation 5 below.

<Relation 5>

$$\sigma = Q \times A$$

In this relation, A is the geometric cross-section value of a scattering body (phosphor-matrix composite), and the calculated scattering coefficient $\mu_s$ is represented by Relation 6 below.

<Relation 6>

$$\mu_s = \text{s} \times \text{D}$$

In this relation, D is the number density of a scattering body.

In Relation 4 to 6 regarding the size of the composite powder versus the scattering coefficient, the phosphor-matrix composite having a size of at least 20 $\mu$m and preferably 30 $\mu$m or more may significantly reduce the scattering coefficient due to the crystal structure.

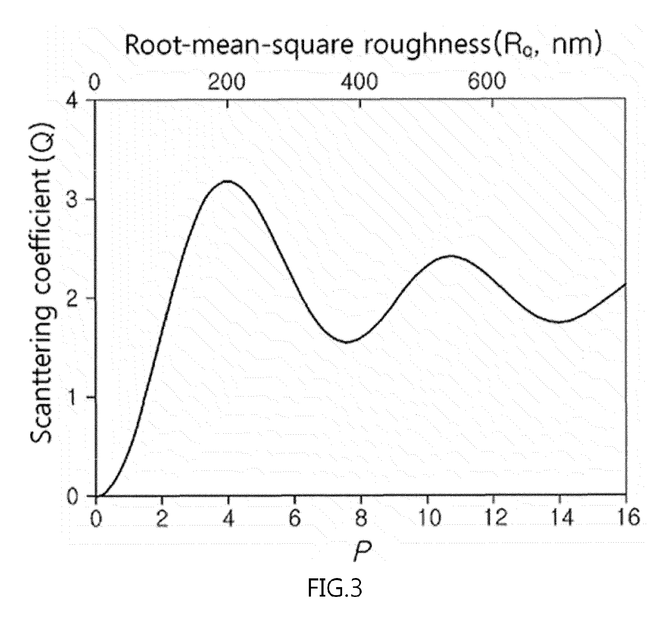

In addition to the condition a) of Relation 3, $R_q$ of the composite corresponding to the condition b) of Relation 3 should be 50 nm or less. Specifically, FIG. 3 is a graph illustrating the $R_q$ versus the scattering coefficient of the composite. When $R_q$ is preferably 50 nm or less, the scattering coefficient may be remarkably decreased due to $R_q$.

$R_q$ of the composite may be measured using a typical method, for example, a method disclosed in Korean Patent Application No. 2005-126461, but the present invention is not limited thereto.

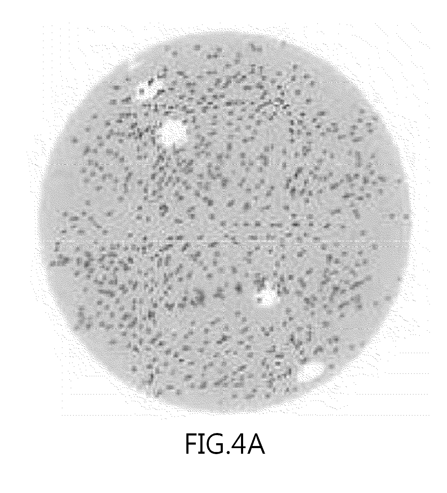

The inside and the surface of the composite may be variously formed so long as they satisfy the conditions of the crystal particles as mentioned above. Preferably, the composite may have a spherical shape of FIG. 4A or a cubic shape within a range satisfying the conditions of Relation 3, but the present invention is not limited thereto. Any composite satisfying Relation 3 may be incorporated into the scope of the present invention. FIG. 4A schematically illustrates a composite according to a preferred embodiment of the present invention, which is a spherical composite comprising a matrix and phosphors and/or quantum dots dispersed therein, or is an organic dye-linked organic-inorganic nanocomposite having a spherical shape.

Useful in the present invention, the composite may be a monocrystal-matrix composite or a polycrystal-matrix composite, within the range satisfying Relation 3. When the composite is a monocrystal-matrix composite, the composite comprises nano-sized monocrystals and the matrix. For the polycrystal-matrix composite, a plurality of polycrystal particles agglomerate with the matrix, thus forming a single structure. Thus, in the monocrystal-matrix composite or the polycrystal-matrix composite, the agglomerated composite is regarded as a single composite, and thus the size and the $R_q$ thereof are determined. When the composite is the monocrystal-matrix composite or the polycrystal-matrix composite, the size of individual monocrystals or polycrystals thereof may be set to 100 nm or less to form a monocrystal or polycrystal composite. If the size of the individual monocrystals or polycrystals of the monocrystal-matrix composite or the polycrystal-matrix composite exceeds 100 nm, the scattering coefficient and scattering efficiency based on the Mie scattering principle may increase, undesirably increasing light emission loss of the composite and the blue excided light due to scattering of visible light. Furthermore, the polycrystal-matrix composite is very favorable in terms of minimizing scattering when the pore size defined by the individual polycrystals thereof is 50 nm or less.

Usable in the present invention, another composite may be an organic dye-linked organic-inorganic nanocomposite within the range satisfying Relation 3. The organic dye mainly includes organic molecules having a size of 10 nm or less as a small molecular material. When the composite is formed through bridging with oligosiloxane, light scattering does not occur and the organic-inorganic matrix formed by condensation is also transparent, thus causing no scattering. Thus, when the dye-bridged organic-inorganic matrix composite satisfies the conditions of Relation 3, scattering may be minimized.

As for the white pc-LED including the composite powder for minimizing scattering, the internal quantum efficiency (~ 90%) of the phosphor is 70% or more when considering the quantum efficiency of a conventional composite, the results of minimized scattering/reflection loss may be applied to the light conversion efficiency, and thus not only the conventional powder phosphor but also the nanophosphor or the phosphor-matrix composite powder may be replaced.

Meanwhile, the present invention pertains not to chemical conditions but to physical conditions of the composite and the phosphors and/or quantum dots and the matrix contained therein. Therefore, any matrix may be used without particular limitation so long as it is used in the phosphor and the composite as the light source for absorbing blue or near-ultraviolet light to emit visible light.

The phosphors useful in the invention may include an inorganic phosphor, such as a YAG phosphor, an oxide, a nitride, an oxynitride, a sulfide, a rare earth acid sulfide, a halide, an aluminate chloride, a halophosphate chloride, etc.

Preferably, the phosphors include, but are not limited to, any one or more selected from the group consisting of $(Y_xGd_{1-x})_3(Al_yGa_{1-y})_5O_{12}$:Ce (x = 0.0~3.0, y = 0.0~5.0), $(Tb_xGd_{1-x})_3(Al_yGa_{1-y})_5O_{12}$:Ce (x = 0.0~3.0, y = 0.0~5.0), $Mg_3(Y_xGd_{1-x})_2Ge_3O_{12}$:Ce (x = 0.0~2.0), $CaSc_2O_4$:Ce, $Ca_3Sc_2Si_3O_{12}$: Ce, $(Sr_x,Ba_y,Ca_z)MgSi_2O_6$:Eu,Mn (x, y, z = 0.0-1.0, x+y+z = 1.0), $(Sr_x,Ba_y,Ca_z)_3MgSi_2O_8$:Eu,Mn (x, y, z = 0.0~3.0, x+y+z = 3.0), $(Sr_x,Ba_y,Ca_z)MgSiO_4$:Eu,Mn (x, y, z = 0.0-1.0, x+y+z = 1.0), $Lu_2CaMg_2(Si_x,Ge_{1-x})_3O_{12}$:Ce (x = 0.0-3.0), $(Sr_x,Ba_y,Ca_z)_2SiO_4$:Eu (x, y, z = 0.0-2.0, x+y+z = 2.0), $(Sr_x,Ba_y,Ca_z)_3SiO_5$:Eu (x, y, z = 0.0~3.0, x+y+z = 3.0), $(Sr_x,Ba_y,Ca_z)_3SiO_5$:Ce,Li (x, y, z = 0.0-3.0, x+y+z = 3.0), $Li_2SrSiO_4$:Eu, $LaSr_2AlO_5$:Ce, $Ca_2BO_3Cl$:Eu, $Y_3Mg_2AlSi_2O_{12}$: Ce, $BaMgAl_{10}O_{17}$: Eu, $Sr_2BaAlO_4F$: Ce, $(Sr_x,Ba_y,Ca_z)Ga_2S_4$:Eu (x, y, z = 0.0-1.0, x+y+z = 1.0), $Ba_2ZnS_3$: Ce, Eu, $Ca_2SiS_4$:Eu, Ca$\alpha$-SiALON:Yb, Ca$\alpha$-SiALON:Eu, $\alpha$-SiALON:Yb, $\alpha$-SiALON:Eu, Ca-Li-$\alpha$-SiALON:Eu, $\beta$-SiALON:Eu, $\gamma$-AlON:Mn, $\gamma$-AlON:Mn,Mg, $(Sr_x,Ba_y,Ca_z)_2Si_5N_8$:Eu (x, y, z = 0.0-2.0, x+y+z = 2.0), $(Sr_x,Ba_y,Ca_z)Si_2O_2N_2$:Eu (x, y, z = 0.0-1.0, x+y+z = 1.0), $Ca_xAl_{12}(ON)_{16}$:Eu, $Ba_3Si_6O_{12}N_2$:Eu,

$(Ba_{1-x}Sr_x)_ySi_4O_7:Eu$ (x = 0.0-1.0), $(Ca_{1-x}Sr_x)AlSiN_3:Eu$ (x = 0.0~1.0), and AIN:Eu.

Also, the quantum dots may include, but are not limited to, any one or more selected from the group consisting of $CdSe/ZnS$, $CuInS_2/ZnS$, $Cu_2In_5S_8/ZnS$, $AgInS_2/ZnS$, $Ag_2In_5S_8/ZnS$, and $InP/ZnS$.

The phosphors useful in the invention are preferably transparent in terms of minimizing light scattering.

Further, the matrix for the composite of the invention is described. The matrix is used to disperse the nanophosphors and the quantum dots therein so as to prevent a reduction in light emission through self-absorption of light emitted from the phosphors or the quantum dots. Also, it may play a role in dispersing the nanophosphors or the quantum dots so as not to form clusters at a size able to scatter light.

In the present invention, any matrix may be used without limitation so long as it is typically useful in the phosphor-matrix composite powder, and preferable examples thereof include, but are not limited to, transparent high-refractive materials, such as alumina, silicate, $TiO_2$, $HfO_2$, oligosiloxane, ormercer or silicone binders.

The energy conversion efficiency of the composite may vary depending on the kind or amount of the phosphor particles dispersed in the matrix. Specifically, when the amount of the phosphors and/or the quantum dots or the organic dye is excessively increased, it is difficult to perform sintering, and porosity may increase, thus making it difficult to efficiently radiate excited light onto the phosphors or deteriorating mechanical strength of the composite. In contrast, when the amount of the above components is too low, it is difficult to achieve sufficient light emission. Thus, the mass ratio of the matrix to the phosphors is 99.99 : 0.01 ~ 50 : 50, and preferably 99.95 : 0.05 ~ 70 : 30, and more preferably 99.92 : 0.08 ~ 85 : 15.

The composite powder according to the present invention may be obtained using a typical process for manufacturing a phosphor-matrix composite powder, and preferably a firing process or a curing process.

The composite thus manufactured is bonded to an LED having blue or near-ultraviolet light emission properties, thus forming a light emission device for converting wavelength. Compared to an LED using a conventional phosphor-matrix composite powder, the external quantum efficiency may be increased by 20% or more and the light emission efficiency of 50% or more may be achieved. Specifically, compared to the conventional phosphor-matrix composite powder, the internal quantum efficiency of only the phosphors is decreased by about 10 ~ 15%, but the LED package efficiency including the phosphors according to the invention is increased by 20 ~ 30% or more. Consequently, the external quantum efficiency of a white LED including the composite of the invention and the light emission efficiency expressed by lm/W may be greatly increased to 136 ~ 148 lm/W from 114 lm/W.

In addition, a phosphor-matrix composite powder according to a second embodiment of the present invention is described.

According to the second embodiment of the present invention, the phosphor-matrix composite powder is configured to include a core layer comprising a matrix having a size of 20 μm or more and a shell layer comprising a plurality of phosphors or quantum dots having a size of 100 nm or less, and satisfies the conditions of Relation 3, as in the first embodiment.

Below, a description of the portions that overlap those of the first embodiment is omitted and the different portions are described.

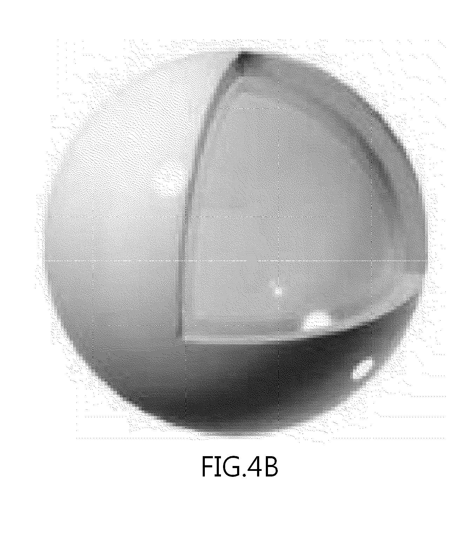

Whereas the composite of the first embodiment is configured such that the phosphors and/or quantum dots are dispersed in the matrix as illustrated in FIG. 4A, the composite of the second embodiment has a core-shell structure configured such that, as illustrated in FIG. 4B, the surface of the matrix layer is covered with the phosphor layer (quantum dot- or dye-bridged organic-inorganic composite).

The matrix, phosphors and quantum dots used in the second embodiment are the same as in the first embodiment but the size of the matrix of the core layer has to be at least 20 μm. If the size of the matrix is less than 20 μm, the scattering coefficient may increase.

The shell layer formed on the core layer may include phosphors and/or quantum dots, with the size of the phosphors and/or quantum dots being 100 nm or less. If the size of the phosphors and/or quantum dots exceeds 100 nm, package efficiency may decrease due to light scattering. Like the first embodiment, the composite of the second embodiment may be an organic dye-linked organic-inorganic nanocomposite.

Further, the shell layer may be 5 ~ 100 nm thick. If the thickness of the shell layer is less than 5 nm, the phosphors or the quantum dots are not applied in a sufficient amount, making it impossible to obtain sufficient light emission. In contrast, if the thickness thereof exceeds 100 nm, light scattering may increase due to the thickness of the phosphors or quantum dots, undesirably increasing loss due to light scattering.

The composite of the second embodiment may be manufactured using a typical method of preparing a core/shell composite, and is preferably obtained by coating the surface of microbeads with phosphors or quantum dots.

According to the present invention, a phosphor-matrix composite powder can be usefully employed in LEDs, illuminations and displays to which a composite serving as a light source for absorbing blue or near-ultraviolet light to emit visible light is applied.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

**Claims**

1. A phosphor-matrix composite powder for minimizing light scattering, comprising a matrix and a plurality of phosphors or quantum dots having a size of 100 nm or less dispersed in the matrix,
   wherein the composite satisfies Relation 3 below and is used as a light source for absorbing blue or near-ultraviolet light to emit visible light:

   <Relation 3>

   a) Composite size $\geq$ 20 $\mu$m; and
   b) Surface root-mean-square-roughness ($R_q$) of composite $\leq$ 50 nm;.

2. A phosphor-matrix composite powder for minimizing light scattering, comprising a core layer comprising a matrix having a size of 20 $\mu$m or more and a shell layer comprising a plurality of phosphors or quantum dots having a size of 100 nm or less, wherein the composite satisfies Relation 3 below and is used as a light source for absorbing blue or near-ultraviolet light to emit visible light:

   <Relation 3>

   a) Composite size $\geq$ 20 $\mu$m; and
   b) Surface root-mean-square-roughness ($R_q$) of composite $\leq$ 50 nm;.

3. The phosphor-matrix composite powder of claim 1 or 2, wherein the composite powder has a size of 30 ~ 500 $\mu$m.

4. The phosphor-matrix composite powder of claim 1 or 2, wherein the composite powder has a spherical shape, a cylindrical shape or a cubic shape.

5. The phosphor-matrix composite powder of claim 1 or 2, wherein the phosphors comprise at least one selected from the group consisting of $(Y_xGd_{1-x})_3(Al_yGa_{1-y})_5O_{12}$:Ce (x = 0.0~3.0, y = 0.0~5.0), $(Tb_xGd_{1-x})_2(Al_yGa_{1-y})_5O_{12}$:Ce (x = 0.0~3.0, y = 0.0~5.0), $Mg_3(Y_xGd_{1-x})_2Ge_3O_{12}$:Ce (x = 0.0~2.0), $CaSc_2O_4$:Ce, $Ca_3Sc_2Si_3O_{12}$:Ce, $(Sr_x,Ba_y,Ca_z)MgSi_2O_6$:Eu,Mn (x, y, z = 0.0-1.0, x+y+z = 1.0), $(Sr_x,Ba_y,Ca_z)_3MgSi_2O_8$:Eu,Mn (x, y, z = 0.0~3.0, x+y+z = 3.0), $(Sr_x,Ba_y,Ca_z)MgSiO_4$:Eu,Mn (x, y, z = 0.0-1.0, x+y+z = 1.0), $Lu_2CaMg_2(Si_x,Ge_{1-x})_3O_{12}$:Ce (x = 0.0-3.0), $(Sr_x,Ba_y,Ca_z)_2SiO_4$:Eu (x, y, z = 0.0-2.0, x+y+z = 2.0), $(Sr_x,Ba_y,Ca_z)_3SiO_5$:Eu (x, y, z = 0.0~3.0,x+y+z = 3.0), $(Sr_x,Ba_y,Ca_z)_3SiO_5$:Ce,Li (x, y, z = 0.0-3.0, x+y+z = 3.0), $Li_2SrSiO_4$:Eu, $LaSr_2AlO_5$:Ce, $Ca_2BO_3Cl$:Eu, $Y_3Mg_2AlSi_2O_{12}$:Ce, $BaMgAl_{10}O_{17}$:Eu,$Sr_2BaAlO_4F$:Ce, $(Sr_x,Ba_y,Ca_z)Ga_2S_4$:Eu (x, y, z = 0.0-1.0, x+y+z = 1.0), $Ba_2ZnS_3$: Ce, Eu, $Ca_2SiS_4$:Eu, Ca$\alpha$-SiALON:Yb, Ca$\alpha$-SiALON:Eu, $\alpha$-SiALON:Yb, $\alpha$-SiALON:Eu, Ca-Li-$\alpha$-SiALON:Eu, $\beta$-SiALON:Eu, $\gamma$-AlON:Mn, $\gamma$-AlON:Mn,Mg, $(Sr_x,Ba_y,Ca_z)_2Si_5N_8$:Eu (x, y, z = 0.0-2.0, x+y+z = 2.0), $(Sr_x,Ba_y,Ca_z)Si_2O_2N_2$:Eu (x, y, z = 0.0-1.0, x+y+z = 1.0), $Ca_xAl_{12}(ON)_{16}$:Eu, $Ba_3Si_6O_{12}N_2$:Eu, $(Ba_{1-x}Sr_x)_YSi_4O_7$:Eu (x = 0.0-1.0), $(Ca_{1-x}Sr_x)AlSiN_3$:Eu (x = 0.0-1.0), and AlN:Eu.

6. The phosphor-matrix composite powder of claim 1 or 2, wherein the composite powder is transparent.

7. The phosphor-matrix composite powder of claim 1 or 2, wherein a mixing ratio of the matrix and the phosphors is 99.99 : 0.01 - 50 : 50 by mass.

8. The phosphor-matrix composite powder of claim 1 or 2, wherein the matrix comprises a transparent material having a high refractive index.

9. The phosphor-matrix composite powder of claim 1 or 2, wherein the matrix is alumina, silicate, $TiO_2$, $HfO_2$,$CeO_2$, $Y_2O_3$, $Gd_2O_3$ or a silicone-based resin.

10. The phosphor-matrix composite powder of claim 1 or 2, wherein the quantum dots comprise at least one selected from the group consisting of CdSe/ZnS, $CuInS_2$/ZnS, $Cu_2In_5S_8$/ZnS, $AgInS_2$/ZnS, $Ag_2In_5S_8$/ZnS, and InP/ZnS.

11. The phosphor-matrix composite powder of claim 1 or 2, wherein the composite is an organic dye-linked organic-inorganic nanocomposite.

12. The phosphor-matrix composite powder of claim 11, wherein the organic dye-linked organic-inorganic nanocomposite is an organic dye-bridged organic-inorganic nanocomposite.

13. The phosphor-matrix composite powder of claim 12, wherein the organic dye-bridged organic-inorganic nanocomposite is prepared by subjecting a red dye- or green dye-bridged alkoxysilane-based nanocomposite to a sol-gel reaction to prepare an oligosiloxane composite which then undergoes a condensation reaction.

14. The phosphor-matrix composite powder of claim 2, wherein the shell layer has a thickness of 5 ~ 100 nm.

15. An LED structure, comprising a blue or near-ultraviolet LED and the composite of claim 1 or 2 bonded thereto.

FIG.1

FIG.2

FIG.3

FIG.4A

FIG.4B

# EP 2 811 001 A1

<table>
<tr><td colspan="2">INTERNATIONAL SEARCH REPORT</td><td>International application No.</td></tr>
<tr><td colspan="2"></td><td>**PCT/KR2013/000707**</td></tr>
</table>

**A.    CLASSIFICATION OF SUBJECT MATTER**

***C09K 11/08(2006.01)i, C09K 11/00(2006.01)i, C09K 11/54(2006.01)i***

According to International Patent Classification (IPC) or to both national classification and IPC

**B.    FIELDS SEARCHED**

Minimum documentation searched (classification system followed by classification symbols)
C09K 11/08; G06F 17/00; H01L 21/66

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: phosphor, matrix, composite

**C.    DOCUMENTS CONSIDERED TO BE RELEVANT**

| Category* | Citation of document, with indication, where appropriate, of the relevant passages | Relevant to claim No. |
|---|---|---|
| Y | PARK, B.K. et al., Selecting Morphology of Y3Al5O12:Ce3+ Phosphors for Minimizing Scattering Loss in the pc-LED Package. J. Electrochem. Soc. vol. 159, no. 4, 26 January 2012 Pages J96-J105 | 1,3-9,15 |
| A | | 2,10-14 |
| Y | KR 10-2009-0122210 A (CREE, INC.) 26 November 2009 Claims 1, 17 and the detailed description [0075],[0101],[0105],[0115] | 1,3-9,15 |
| A | | 2,10-14 |
| A | WO 2010/058162 A2 (NACOCO TECHNOLOGIES LTD) 27 May 2010 Claims 1-5 and pages 25-29 | 1-15 |
| A | KR 10-2009-0020676 A (HOYA CORPORATION) 26 February 2009 Claims 1, 5-6 and the detailed description [0043],[0087],[0089],[0094] | 1-15 |

☐  Further documents are listed in the continuation of Box C.        ☒  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 MAY 2013 (27.05.2013) | **27 MAY 2013 (27.05.2013)** |

| Name and mailing address of the ISA/KR | Authorized officer |
|---|---|
| Korean Intellectual Property Office Government Complex-Daejeon, 189 Seonsa-ro, Daejeon 302-701, Republic of Korea | |
| Facsimile No.  82-42-472-7140 | Telephone No. |

Form PCT/ISA/210 (second sheet) (July 2009)

INTERNATIONAL SEARCH REPORT
Information on patent family members

International application No.

**PCT/KR2013/000707**

| Patent document cited in search report | Publication date | Patent family member | Publication date |
|---|---|---|---|
| KR 10-2009-0122210 A | 26.11.2009 | CN 101627481 A | 13.01.2010 |
| | | CN 101663767 A | 03.03.2010 |
| | | CN 102544267 A | 04.07.2012 |
| | | EP 2111648 A2 | 28.10.2009 |
| | | EP 2111649 A2 | 28.10.2009 |
| | | JP 2010-517289 A | 20.05.2010 |
| | | JP 2010-517290 A | 20.05.2010 |
| | | JP 2012-060181 A | 22.03.2012 |
| | | KR 10-2009-0115156 A | 04.11.2009 |
| | | US 2008-0173884 A1 | 24.07.2008 |
| | | US 2008-0179611 A1 | 31.07.2008 |
| | | WO 2008-091319 A2 | 31.07.2008 |
| | | WO 2008-091319 A3 | 18.09.2008 |
| | | WO 2008-115213 A2 | 25.09.2008 |
| | | WO 2008-115213 A3 | 18.12.2008 |
| | | WO 2008-115213 A8 | 30.04.2009 |
| WO 2010/058162 A2 | 27.05.2010 | AU 2009-317049 A1 | 27.05.2010 |
| | | AU 2009-317049 A2 | 27.05.2010 |
| | | CA 2743244 A1 | 27.05.2010 |
| | | CN 102217106 A | 12.10.2011 |
| | | EP 2351113 A2 | 03.08.2011 |
| | | GB 0821122 D0 | 24.12.2008 |
| | | IL 212953 D0 | 31.07.2011 |
| | | JP 2012-509604 A | 19.04.2012 |
| | | KR 10-2011-0084324 A | 21.07.2011 |
| | | TW 201036214 A | 01.10.2010 |
| | | US 2010-0123155 A1 | 20.05.2010 |
| | | WO 2010-058162 A2 | 27.05.2010 |
| | | WO 2010-058162 A3 | 14.10.2010 |
| KR 10-2009-0020676 A | 26,02,2009 | EP 2040514 A1 | 25.03.2009 |
| | | US 08089061 B2 | 03.01.2012 |
| | | US 2009-0242871 A1 | 01.10.2009 |
| | | WO 2007-142203 A1 | 13.12.2007 |

Form PCT/ISA/210 (patent family annex) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 2005126461